# EUROPEAN PATENT APPLICATION

(11) **EP 4 769 367 A1**
(43) Date of publication of application: **01.07.2026**
(21) Application number: 24905127.7
(22) Date of filing: 15.07.2024
(51) Int. Cl.: G09F 9/30

(54) **DISPLAY MODULE AND DISPLAY DEVICE**

(30) Priority: 21.06.2024 CN 202410808821
(71) Applicant: Wuhan China Star Optoelectronics Semiconductor Display Technology Co., Ltd., Wuhan, Hubei 430079 (CN)
(72) Inventor: HUANG, Wei, Wuhan, Hubei 430079 (CN)
(74) Representative: Murgitroyd & Company
(86) International application number: PCT/CN2024/105475
(87) International publication number: WO 2025/260430

(57) **Abstract**

Disclosed herein is a display module and a display device, which includes a display panel and a flexible circuit board. The display panel includes a display part, a first binding part and a wiring part, and the flexible circuit board includes a second binding part, a first extension part and a second extension part that are inter-connected, the second binding part are bound and connected to the first binding part, the first extension part overlaps the wiring part, a width of the second extension part is smaller than a width of the first extension part, and is larger than two-thirds of the width of the first extension part.

## Description

The present application claims priority to Chinese Patent Application No. 202410808821.1, filed on June 21, 2024, the disclosure of which is incorporated herein by reference in its entirety.

### TECHNICAL FIELD

The present application relates to the field of display technology, and specifically to a display module and a display device.

### BACKGROUND

A flexible circuit board in the display device is usually bound and connected to a binding region of a display panel in the display device to perform transmission of data signals. After the flexible circuit board is bound and connected to the binding terminals in the display panel, it extends toward an end away from the display panel, and an extension part of the flexible circuit board occupies an internal space of the display device.

### SUMMARY

The present application provides a display module and a display device to remedy the technical problem of compact internal space layout of the existing display device.

In a first aspect, the present application provides a display module, which includes:
a display panel including a display part, a first binding part located at a side of the display part, and a wiring part located between the first binding part and the display part, the first binding part being provided with a plurality of first terminals;
a flexible circuit board including:
a second binding part, the second binding part being provided with a plurality of second terminals, and the second terminals being bound and connected to the corresponding first terminals;
a first extension part connected to the second binding part, the first extension part extends in a direction from the second binding part toward the display part, and an orthographic projection of the first extension part on the display panel being located in the wiring part;
a second extension part connected to the second binding part, the second extension part extending from the second binding part to a side away from the first extension part;
in which, in a direction from the first extension part to the second extension part, a width of the first extension part is greater than a width of the second extension part, and a width of the second extension part is greater than three-thirds of a width of the first extension part.

In a second aspect, the present application also proposes a display device, which includes the above-mentioned display module.

### DESCRIPTION OF THE DRAWINGS

FIG. 1 is a schematic diagram of a connection between the display panel and the flexible circuit board in a display module provided by the present application;
FIG. 2 is a schematic diagram of a connection between the display panel and the flexible circuit board in a display module of the present application;
FIG. 3 is a partial cross-sectional view of the display module of the present application;
FIG. 4 is a first structural diagram of the flexible circuit board in the display module of the present application;
FIG. 5 is a structural diagram of a single-layer plate on the lowest single-layer plate of the flexible circuit board in the display module of the present application;
FIG. 6 is a second structural diagram of the flexible circuit board in the display module of the present application;
FIG. 7 is a cross-sectional view of section AA in FIG. 6;
FIG. 8 is a fourth structural diagram of the flexible circuit board in the display module of the present application;
FIG. 9 is a fifth structural diagram of the flexible circuit board in the display module of the present application;
FIG. 10 is a cross-sectional view of section MM in FIG. 4.

### DESCRIPTION OF THE EMBODIMENTS

The technical solutions in the embodiments of the present application will be clearly and completely described below with reference to the accompanying drawings in the embodiments of the present application. Obviously, the described embodiments are only some of the embodiments of the present application, but not all of the embodiments. Based on the embodiments in the present application, all other embodiments obtained by those skilled in the art without making creative efforts fall within the scope of protection of the present application. In addition, it should be understood that the specific embodiments described herein are only intended to illustrate and explain the present application, and are not meant to limit the present application.

In the description of the present application, it is to be understood that the orientations or positional relationships indicated by the terms "length", "width", "thickness", "upper", "lower", "front", "back", "left", "right", "top", "bottom", "inner", "outer" and the like are the orientations or positional relationships shown based on the drawings. They are only for the convenience of describing the present application and simplifying the description, and do not indicate or imply that the referred device or element must have a specific orientation, are constructed and operated in a specific orientation and therefore should not be construed as limiting the present application.

In addition, the terms "first" and "second" are only used for descriptive purpose and cannot be understood as indicating or implying relative importance or implicitly indicating the quantity of the indicated technical features. Therefore, the features defined as "first" and "second" may explicitly or implicitly include one or more features. In the description of the present application, "plurality of" means two or more, and at least one means one, two, or more than two, unless otherwise clearly and specifically limited.

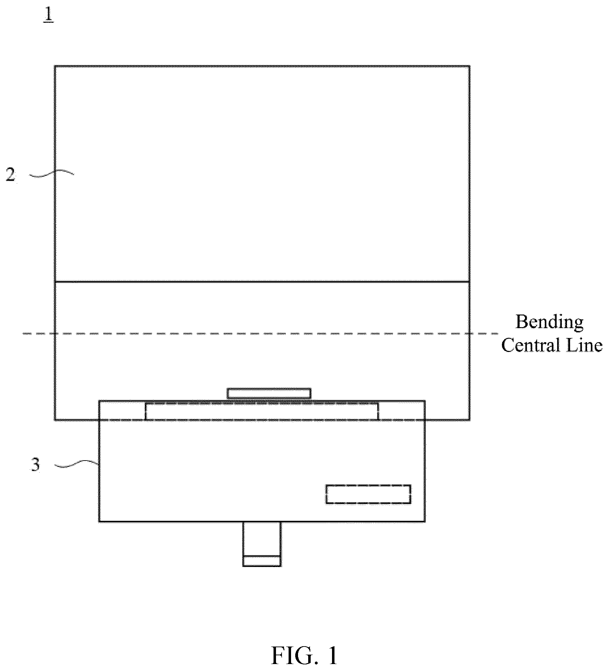

Please refer to FIG. 1, which is an expanded structural view of an existing display device. The existing display device 1 includes a display panel 2 and a flexible circuit board 3. The flexible circuit board 3 is bound and connected to the terminals on the display panel 2, and the flexible circuit board 3 extends in a direction away from the display panel 1. The flexible circuit board 3 has an extension part which has a certain size and occupies the internal space of the display device. The present application proposes a display module based on such technical problem.

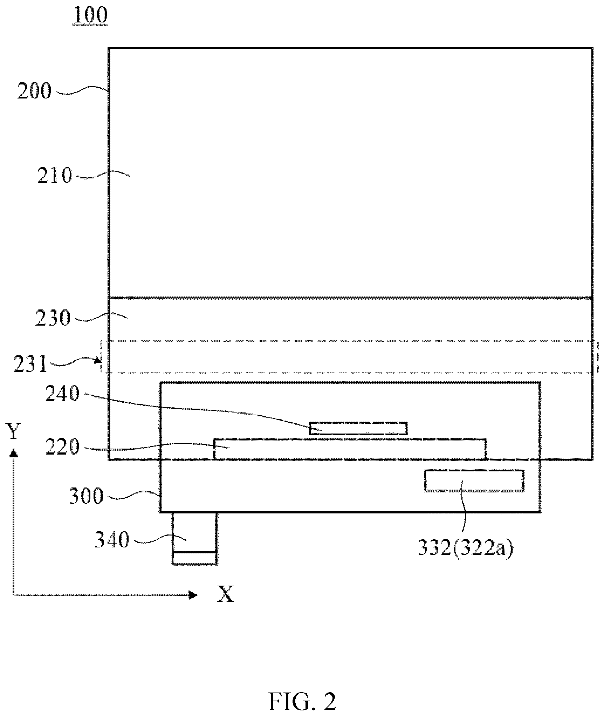

With reference to FIGS. 2 to 9, the present application provides a display module 100, which may include a display panel 200 and a flexible circuit board 300 bound and connected to the display panel 200.

In the present embodiment, the display panel 200 may include a display part 210, a first binding part 220 located at a side of the display part 210, and a wiring part 230 located between the first binding part 220 and the display part 210. A plurality of first terminals 220a are provided on the binding part 220. The flexible circuit board 300 may include a second binding part 310. The second binding part 310 is provided with a plurality of second terminals 310a, and the second terminals 310a are bound and connected to the corresponding first terminals 220a.

In the present embodiment, the flexible circuit board 300 further includes a first extension part 320 connected to the second binding part 310. The first extension part 320 extends in a direction from the second binding part 310 toward the display part 210, and an orthographic projection of the first extension part 320 on the display panel 200 is located in the wiring part 230.

In the present embodiment, the flexible circuit board 300 further includes a second extension part 330 connected to the second binding part 310. The second extension part 330 extends from the second binding part 310 to the side away from the first extension part 320.

In the present embodiment, in the direction from the first extension part to the second extension part, the width of the first extension part is greater than the width of the second extension part, and the width of the second extension part is greater than two-thirds of the width of the first extension part.

In the present application, by making the first extension part 320 of the flexible circuit board 300 overlap the wiring part 230 of the display panel 200, the flexible circuit board 300 are bound and connected to the terminals on the display panel 200, and the first extension part 320 is attached to the wiring part230. Compared with the structure of FIG. 1 , the flexible circuit board 300 of the present application is reversely bound, which is equivalent to moving the extension part of the flexible circuit board 300 from the end away from the display panel 200 to above the wiring part 230 , that is, the extension part in the flexible circuit board 300 can be attached to the surface of the wiring part 230 of the display panel 200. Meanwhile, in the direction from the first extension part 320 to the second extension part 330, the width of the second extension part 330 is made smaller than the width of the first extension part 320 and larger than two-thirds of the width of the first extension part 320. Under the condition of ensuring that the second extension part 330 has enough area for the adsorption fixture to absorb, the width of the second extension part 330 cannot exceed the width of the first extension part 320, and the width of the second extension part 330 is deceased as much as possible to reduce the space occupied by the flexible circuit board 300 inside the display module 100, which remedies the technical problem of compact internal space layout of the display device. At the same time, the space reduced by the flexible circuit board 300 can be used to arrange the battery of the product, thereby increasing the capacity of the battery and raising the endurance of the product.

It is to be noted that the width direction in the present application is the direction from the first extension part 320 to the second extension part 330 in the flexible circuit board 300, and the thickness direction is the direction perpendicular to the light exiting surface of the display panel 200.

It is to be noted that the display panel 200 of the present application may be a flexible panel. For example, the wiring part 230 includes a bending part 231. After the bending part 231 is bent, the first binding part 220 may be bent to the side of the display part 210 away from the light emitting direction.

It is to be noted that after the display panel 200 and the flexible circuit board 300 are bound, the display panel 200 needs to be bent. When the display panel 200 is bent, the flexible circuit board 300 needs to be flipped from the light exit surface of the display panel 200 to the backlight surface of the display panel 200, so the flexible circuit board 300 needs to be adsorbed by the adsorption fixture to realize the flipping of the flexible circuit board 300.

In the present embodiment, since the second extension part 330 extends toward the side away from the first extension part 320, there is enough space on the second extension part 330 to provide the adsorption region 331, and the adsorption fixture may be adsorbed on the adsorption region 331 of the second extension part 330 to realize the flipping of the flexible circuit board 300, while there is no need to design an additional compensation structure for the adsorption fixture to adsorb.

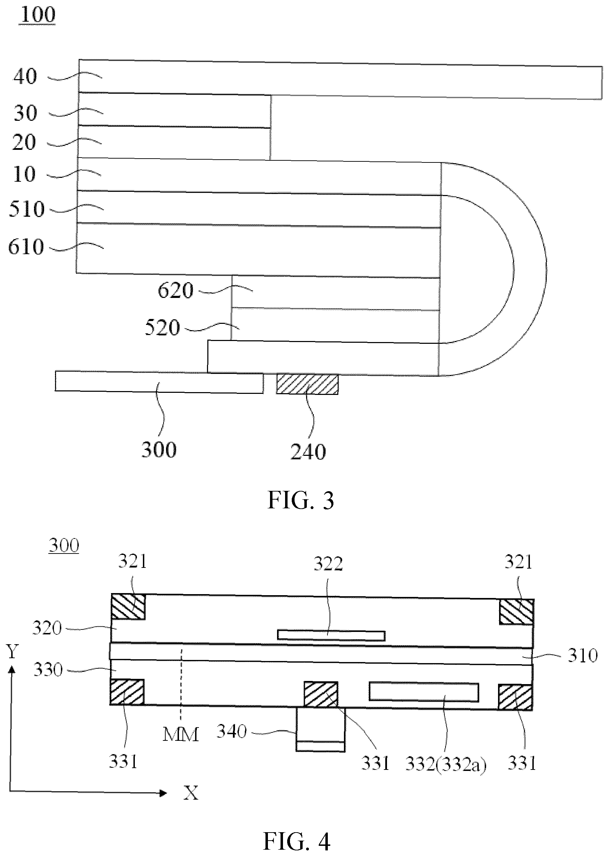

It to be noted that the display panel 200 may be an organic light-emitting display panel; For example, taking the organic light-emitting display panel as an example, please refer to FIG. 3. The display panel 200 may include a display layer 10. The display layer 10 may include a base substrate, an array driving layer disposed on the base substrate, and a pixel definition layer disposed on the array driving layer, a light-emitting device layer disposed on the same layer as the pixel definition layer, an encapsulation layer disposed on the pixel definition layer, and a polarizer layer 30 disposed on the encapsulation layer.

In the present embodiment, please with reference to FIG. 3, the display panel 200 may further include a touch layer 20, a polarizer layer 30, a cover layer 40, etc.; Secondly, the display panel 200 can further include a color filter layer (not shown), and at least one of the color filter layer and the polarizer layer 30 may be selected according to the specific structure. The position of the touch layer 20 may be disposed on the packaging layer or between the packaging layer and the base substrate, which is not specifically limited in the present application.

In the present embodiment, the base substrate is used to support each of the film layers provided on the base substrate, and the base substrate may be a flexible substrate that can be bent, folded, rolled, etc. Examples of a flexible material for the flexible substrate include, but are not limited to, polyimide (PI).

In the present embodiment, the array driving layer may include a plurality of thin film transistors. The thin film transistors may be of an etching barrier type, a back channel etching type, or they may be divided into bottom gate thin film transistors and top gate thin film transistors according to the positions of the gate electrode and the active layer, or they are divided into N-type thin film transistors, P-type thin film transistors according to the performance of the thin film transistors.

It is to be noted that the light-emitting device of the display panel 200 of the present application may also be a Mini LED, a Micro LED or other small-sized light-emitting devices.

In the present embodiment, please refer to FIG. 3, the display panel 200 further includes a first back plate 510 and a second back plate 520 that are separately provided. The material of the back plate may be polyethylene terephthalate (PET).

In the present embodiment, please refer to FIG. 3, the display panel 200 further includes a first support layer 610 and a second support layer 620 disposed between the first back plate 510 and the second back plate 520. The first support layer 610 and the first back plate 510 is bonded through a glue layer, the second support layer 620 and the second back plate 520 are bonded through a glue layer. The material of the first support layer 610 may be stainless steel, and the material of the second support layer 620 may be foam, or polyethylene terephthalate (PET), etc.

It is to be noted that in the following embodiments, the arrangement direction of the plurality of first terminals 220a in the display panel 200 is a first direction X. Before the display panel 200 is not bent, the direction from the first binding part 220 to the display part 210 is a second direction Y.

The structure of the flexible circuit board 300 of the present application will now be described with reference to the specific embodiments.

In the present embodiment, the second binding part 310 includes a layer of single-layer plates 400, and both the first extension part 320 and the second extension part 330 include at least two layers of stacked single-layer plates 400.

The present application utilizes at least two layers of the stacked single-layer plates 400 to constitute the first extension part 320 and the second extension part 330, increasing the wiring space of the two extension parts in the thickness direction, reducing the width of the two extension parts, and decreasing the space occupied by the extension parts of the flexible circuit board 300 inside the display device, which remedies the technical problem of compact internal space layout of the display device. Meanwhile, the space reduced by the flexible circuit board 300 can be used to arrange the battery of the product, thereby increasing the capacity of the battery and raising the endurance of the product.

In the present embodiment, the second binding part 310 may include one layer or two or more layers of the stacked single-layer plates 400 , and the first extension part 320 and the second extension part 330 may include at least two layers of the stacked single-layer plates 400, an increase in the number of the single-layer plates 400 can increase the wiring space of the flexible circuit board 300 in the thickness direction, thereby reducing the width of the flexible circuit board 300; In the following embodiment, the second binding part 310 only includes a single-layer plate 400 as an example for description.

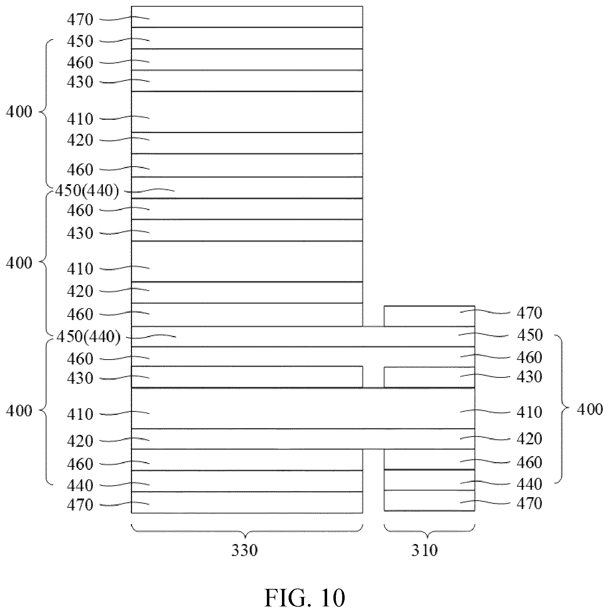

Please refer to Figure 10, which is a cross-sectional view of section MM in Figure 4. FIG. 10 only lists the cross-sectional view of the second binding part 310 and the second extension part 330. The second binding part 310 includes one layer of the single-layer plate 400, and the second extension part 330 includes three layers of the single-layer plate 400.

In the structure of FIG. 10, each of the single-layer plates 400 may include an insulating substrate 410, a first conductive layer 420, a first insulating layer 440, a second conductive layer 430 and a second insulating layer 450. The first conductive layer 420 is provided on the surface of a side of the insulating substrate 410 close to the display panel 200, the first insulating layer 440 is provided on the surface of a side of the first conductive layer 420 close to the display panel 200, the second conductive layer 430 is provided on the surface of the side of the insulating substrate 410 away from the display panel, the second insulating layer 450 is disposed on the surface of the side of the second conductive layer 430 close to the display panel 200.

In the present embodiment, the material of the insulating substrate 410 may be a flexible insulating material such as polyimide, and the first conductive layer 420 and the second conductive layer 430 may be made of a metal material with good conductivity such as metallic copper. The material of the insulating layer 440 and the second insulating layer 450 may be a flexible insulating material such as polyimide.

In the structure of FIG. 10, the first conductive layer 420 may be formed by stacking a double-layer copper layers. An insulating glue material 460 is disposed each of between the first insulating layer 440 and the first conductive layer 420 and between the second insulating layer 450 and the second conductive layer 430. The insulating layer and the conductive layer are bonded via the insulating glue material; meanwhile, an electromagnetic shielding layer 470 is further provided on the surface of the outermost first insulating layer 440 and the second insulating layer 450 to shield the interference of the external electrical signals on the inside of the flexible circuit board 300.

In the second extension part 330 of FIG. 10, one layer of the insulating layer may be shared between two adjacent single-layer plates 400, for example the second insulating layer 450 of the middle single-layer plate 400 and the first insulating layer 440 of the upper single-layer plate 400 are shared; the first insulating layer 440 of the middle single-layer plate 400 and the second insulating layer 450 of the lower single-layer plate 400 are shared.

In the structure of FIG. 10, the single-layer plate 400 in the second binding part 310 and the lowest single-layer plate 400 in the second extension part 330 are arranged on the same layer, for example, the insulating substrate 410, the first conductive layer 420, the first insulating layer 440, the second conductive layer 430 and the second insulating layer 450 in the respective single-layer plate 400 are all formed in the same process.

In the structure of Figure 10, the second binding part 310 is provided with one layer of the insulating substrate 410 and two layers of the conductive layers, the second extension part 330 is provided with three layers of the insulating substrates 410 and six layers of the conductive layers; the multi-layer stacked conductive layers increase the wiring space of the flexible circuit board 300 corresponding to the extension part, and reduce the width of the extension part.

It is to be noted that the structure of the first extension part 320 of the present application may be the same as the structure of the second extension part 330.

It is to be noted that the first terminals 220a on both sides of the first binding part 220 are usually connected to the sensing electrode line and the driving electrode line in the touch layer, while the conductive layer in the first extension part 320 connects the electrode line that transmits the same induction signal on both sides or the electrode line that transmits the same drive signal to form a loop.

It is to be noted that since the single-layer plate 400 has poor water and oxygen resistance, the water and oxygen can intrude into the display panel through the metal circuit layer in the flexible circuit board 300, causing abnormality of the display panel. Therefore, the additional back adhesive is required at the steps of the flexible circuit board 300 and the display panel 200; while in the present application, by stacking the multi-layer single-layer plates 400 to arrange the first extension part 320 and the second extension part 330, the arrangement of the insulating layer in the outer single-layer plate 400 can be used as a protective layer of the flexible circuit board, which not only avoids water and oxygen from intruding into the flexible circuit board 300, but also prevents water and oxygen from intruding into the display panel 200 through the flexible circuit board 300; meanwhile, the arrangement of the multi-layer single-layer plates 400 decreases the step difference between the second extension part 300 and the back surface of the display panel 200, and reduces the arrangement for the back adhesive.

It is to be noted that the surface of the electromagnetic shielding layer 470 toward the display panel 200 is further provided with an adhesive glue material (not shown) for bonding the flexible circuit board 300 to the display panel 200.

Since the second extension part 330 of the present application needs to be adsorbed by the adsorption fixture, the second extension part 330 needs to be provided with an adsorption region 331, and the surface roughness of the adsorption region 331 needs to be less than a certain value in order to be adsorbed by the adsorption fixture.

Please refer to FIG. 4. The second extension part 330 includes an adsorption region 331 and a functional region 332. The functional region 332 is provided with a functional element 332a. The adsorption region 331 are not overlapped with the functional region 332.

In the present embodiment, the adsorption region 331 is used for adsorption by the adsorption fixture, and the surface needs to be smooth, while the functional region 332 is used for setting the functional components 332a. The surface of the functional region 332 cannot be adsorbed by the adsorption fixture, so the adsorption region 331 are not overlapped with the functional region 332, that is, the adsorption region 331 and the functional region 332 are arranged at interval.

In the present embodiment, in order to ensure that the adsorption fixture has sufficient adsorption force on the surface of the adsorption region 331, the surface roughness of the adsorption region 331 needs to be small enough. Therefore, on the surface of the second extension 330 away from the display panel 200, the surface roughness of the adsorption region 331 is smaller than the surface roughness of the functional region 332; for example, the surface of the adsorption region 331 is a flat surface.

In the present embodiment, three adsorption regions 331 may be provided on the second extension part 330, and two of the three adsorption regions 331 may be disposed on both sides of the second extension part 330, that is, the two adsorption regions 331 may be disposed at the end part of the second extension part 330, and the remaining one adsorption region 331 among the three adsorption regions 331 may be disposed at the center region of the second extension part 330, that is, the central line of the adsorption region 331 may coincide with the central line of the second extension part 330, while the functional region 332 of the present application may be located between two adjacent adsorption regions 331 .

It is to be noted that the surface of the adsorption region 331 of the present application cannot be provided with the corresponding functional elements, such as a structure recessed on the surface of the second extension part 330 or a structure protruded on the surface of the second extension part 330.

In the present embodiment, the width and the length of the adsorption region 331 both range from 6 mm to 8 mm; For example, each adsorption region 331 may be a square or rectangular region.

It is to be noted that the functional element 332a may be a resistor, capacitor or other elements.

When the first extension part 320 of the present application is attached to the wiring part 230, the first extension part 320 needs to be pressed so that the first extension part 320 and the wiring part 230 are bonded. When the pressing region of the first extension part 320 is provided with the protruding functional element 332a, the region where the functional element 332a is located cannot be pressed during the bending process of the display panel 200, resulting in the problem of peeling between the first extension part 320 and the display panel 200. The second extension part 330 of the present application is composed of the multi-layer single-layer plates 400, and the functional element 332a is disposed in the non-adsorption region of the second extension part 330. During the bending process of the display panel 200, the adsorption fixture is adsorbed on the adsorption region 331 of the second extension part 330, while the pressing region 321 of the first extension part 320 is pressed, thereby avoiding the problem of peeling between the first extension part 320 and the display panel 200.

Please refer to Figure 4. The first extension part 320 of the present application is provided with two pressing regions 321, and the two pressing regions 321 are respectively provided at both ends of the first extending part 320, and no functional elements are provided on the surface of the pressing region 321; alternatively, the first extension part 320 may all be pressing regions 321 .

In the present embodiment, both the width and the length of the pressing region 321 range from 6 mm to 8 mm; For example, each pressing region 321 may be a square or rectangular region. Alternatively, the area of the pressing region 321 may be the same as the area of the adsorbing region 331.

In the display module 100 of the present application, when the width of the second extension part 330 in the second direction Y is too large, the second extension part 330 will occupy more internal space of the display device. Therefore, in the direction of the first extension part 320 to the second extension part 330, the present application makes the width of the first extension part 320 larger than the width of the second extension part 330, reducing the width of the second extension part 330 as much as possible to prevent the second extension part 330 from occupying the more internal space of the display device.

In the present embodiment, since a metal line layer is also provided on the second extension part 330, when the width of the second extension part 330 is reduced, the arrangement space of the metal line layer on the second extension part 330 will be limited. Therefore, the present application can make the thickness of the first extension part 320 smaller than the thickness of the second extension part 330 by increasing the number of single-layer plates 400 in the second extension part 330, that is, the number of the single-layer plates 400 in the first extension part 320 is smaller than the number of the single-layer plates 400 in the second extension 330; For example, the number of the single-layer plates 400 in the second extension part 330 may be 6 layers, and the number of the single-layer plates 400 in the first extension part 320 may be 4 layers. The thickness of the second extension part 330 is increased so that the metal lines in the second extension part 330 can be arranged in multiple layers, which alleviates the technical problem of small layout space for metal line layers.

Meanwhile, considering the process factors, the number of the single-layer plates 400 in the first extension part 320 of the present application is equal to the number of the single-layer plates 400 in the second extension part 330. For example, the number of the single-layer plates 400 in both of the first extension part 320 and the second extension part 330 may be six layers, that is, each of the single-layer plates 400 in the first extension part 320 and the corresponding single-layer plate 400 in the second extension part 330 may be formed in the same process.

In the display module 100 of the present application, if the width of the first extension part 320 is longer in the direction from the first extension part 320 to the second extension part 330, for example, in the structure of FIG. 2, when the first extension part 320 and the bending part 231 of the wiring part 230 are bonded together, it may suffer from the peeling problem between the first extension part 320 and the bending part 231 due to the effect of gravity. Therefore, the overlapping part of the first extension part 320 and the display panel 200 of the present application cannot exceed the bending part 231; while, since the second extension part 320 needs to be provided with the adsorption region, in order to ensure the area of the adsorption region, the width of the second extension part 330 cannot be too small, and when the width of the second extension part 330 is too large, the space occupied by the second extension part 320 will increase, and the space saved for the entire device will decrease. Therefore, the width of the second extension part 330 of the present application needs to be greater than two-thirds of the width of the first extension part 320.

It is to be noted that in the structure of FIG. 2, a driving chip 240 is further provided in the wiring part 230. The driving chip 240 protrudes from the surface of the display panel 200. Since the first extension part 320 covers the driving chip 240, when the first extension part 320 is attached to the wiring part 230, the position of the first extension part 320 corresponding to the driving chip 240 will exhibit a convex shape, which is not conducive to the attachment of the first extension part 320 to the wiring part 230.

In the present embodiment, please refer to FIG. 4. a first opening 322 is opened on the side of the first extension part 320 toward the display panel 200, and the driving chip 240 is accommodated in the first opening 322; the first opening 322 is provided so that the driving chip 240 can be accommodated in the first opening 322. When the first extension part 320 is attached to the wiring part 230, it does not need to exhibit the convex shape, and the first extension part 320 on the periphery of the driving chip 240 can be attached to the wiring part 230.

In the present embodiment, when the thickness of the first extension part 320 is greater than the thickness of the driving chip 240, the first opening 322 does not dig through the first extension part 320; If the thickness of the first extension part 320 is smaller than the thickness of the driving chip 240, the first opening 322 is a through hole, and a part of the driving chip 240 will protrude from the surface of the first extension part 320 on the side away from the display panel 200; therefore, in order to ensure the flatness of the surface of the first extension part 320, the thickness of the first extension part 320 is usually greater than the thickness of the driving chip 240 .

In the display module 100 of the present application, a plurality of alignment marks are provided in the wiring part 230, and the plurality of alignment marks are not overlapped with the first extension part 320. When the second terminal 310a in the flexible circuit board 300 is bound to the first terminal 220a in the display panel 200, the corresponding alignment marks are required to ensure the accuracy of alignment of the second binding part 310 with the first binding part 220. Therefore if the first extension part 320 covers such region, the alignment marks cannot be obtained, which reduces the accuracy of alignment of the second binding part 310 with the first binding part 220; The present application may provide a plurality of through holes on the first extension part 320, so that when the first extension part 320 is attached to the wiring part 230, the alignment marks are not blocked by the first extension part 320, addressing the technical problem in which the alignment of the binding part 310 with the first binding part 220 is inaccurate.

In the above embodiment, since the second binding part 310 is the single-layer plate 400, the first extension part 320 and the second extension part 330 are multi-layer stacked single-layer plates 400, and in order to reduce the process difficulty, the single-layer plate 400 of the second binding part 310 and the lowest single-layer plate 400 of the first extension part 320 and the second extension part 330 in the present application may be integrally provided, for example, the structure of FIG. 10.

For example, please refer to FIG. 4. In the first direction X, the length of the second binding part 310 is equal to both of the length of the first extension part 320 and the length of the second extension part 330; the first direction X is vertical to the direction from the first extension part 320 to the second extending portion 330.

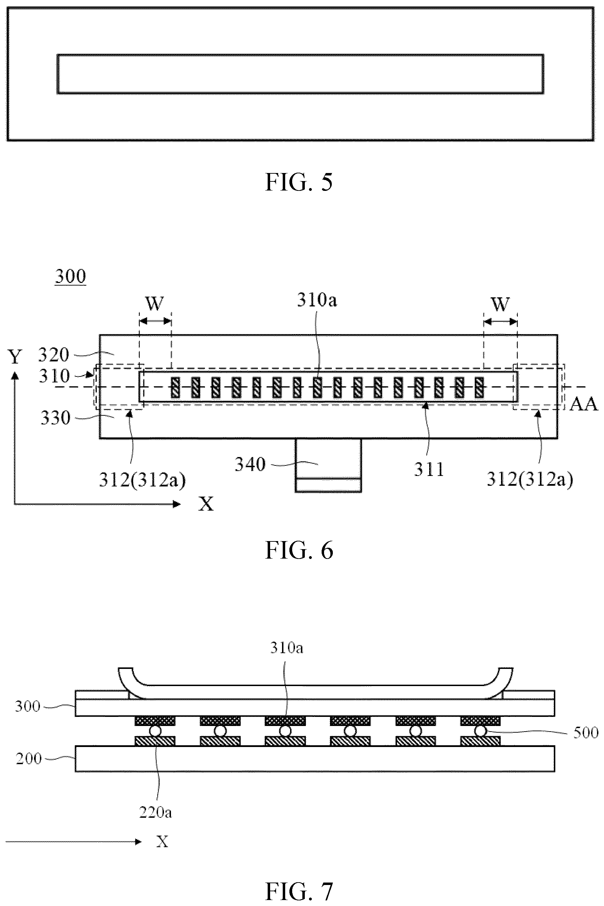

In the present embodiment, the single-layer plate 400 of the second binding part 310 is integrally provided with the lowest single-layer plate 400 of the first extension part 320 and the second extension part 330, and in the multi-layer single-layer plates 400 of the first extension part 320 and the second extension part 330, the upper stacked multi-layer single-layer plates 400 can be directly stacked on the lowermost single-layer plate 400 of the corresponding first extension part 320 and the second extension part 330; Alternatively, the structure of the single-layer plate 400 of the second layer and above in the first extension part 320 and the second extension part 330 may be the structure of FIG. 5 , that is, the region corresponding to the plurality of second terminals 310a in the middle is removed to form the structure of FIG. 6.

Please refer to FIG. 7. FIG. 7 is a cross-sectional view of the interface AA in FIG. 6 of the present application. When the second binding part 310 and the first binding part 220 are bound, the second binding part 310 needs to be pressed with a pressure head. But, since the first extension part 320, the second extension part 330 and the lowermost single-layer plate 400 of the second binding part 310 are integrally arranged, the pressure exerted by the pressure head on the middle region of the second binding part 310 is larger than the pressure exerted on the two side regions of the second binding part 310, and since the first binding part 220 and the second binding part 310 are electrically connected through the conductive particles 500, the pressure to which the conductive particles 500 in the two side regions are subjected is less than the pressure to which the conductive particles 500 in the middle region are subjected, the deformation degree of the conductive particles 500 in the two side regions is different. The contact area between the conductive particles 500 in the middle region and the terminals at both sides is larger than the contact area between the conductive particles 500 in the edge region and the terminals at both sides, thereby causing the differences in the electrical connection effect of the terminals in different regions.

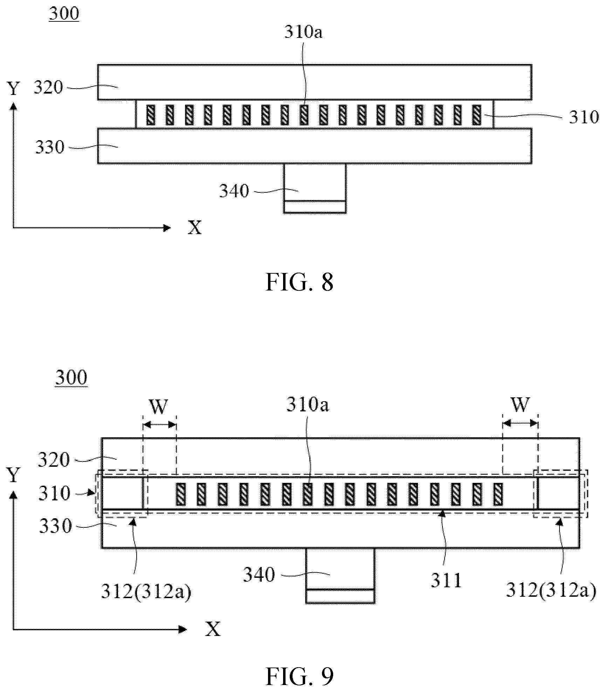

Please refer to FIG. 8. In the first direction X, the length of the second binding part 310 is less than the length of the first extension part 320, and the first direction X is perpendicular to the direction from the first extension part 320 to the second extension part 330.

In the structure of FIG. 8, the length of the second binding part 310 in the first direction X is smaller than the length of the first extension part 320 and the length of the second extension part 330 in the first direction, that is, it is equivalent to removing part of the single-layer plate 400 at both ends of the second binding part 310 in the first direction X and the multi-layer plate structure above such region are removed; alternately, it is equivalent to removing part of the single-layer plate 400 structure at both ends of the second binding part 310 in the first direction X in FIG. 4.

In the structure of FIG. 8, the area of the second binding part 310 is reduced, so that the pressure exerted by the pressure head on each region of the second binding part 310 is more uniform, remedying the technical problem that the differences in the pressure exerted by the pressure head on the middle region and two side regions of the second binding part 310 is larger, and further remedying the technical problem in which the pressure to which the conductive particles 500 on both side regions are subjected is different from the pressure to which the conductive particles on the middle region is subjected. This makes the contact area between the conductive particles 500 on the middle region and the terminals on both sides equal to the contact area between the conductive particles 500 in the edge region and the terminals on both sides.

In the structure of Figure 9, the second binding part 310 includes a binding region 311 and a filling region 312 provided on both sides of the binding region 311, and a plurality of second terminals 310a are provided in the binding region 311; Each filling region 312 is further provided with a filling part 312a. The sum of the thickness of the filling part 312a and the thickness of the second binding part 310 is equal to the thickness of the first extension part 320 or the thickness of the second extension part 330.

Meanwhile, the pressure exerted by the pressure head on the middle region of the second binding part 310 is more uniform. Therefore, the spacing distance between two adjacent second terminals 310a in the binding region 311 in FIG. 9 of the present application may be smaller than the spacing distance between two adjacent second terminals 310a in FIG. 8. That is, this is equivalent to gathering the plurality of second terminals 310a in FIG. 9 toward the middle region of the second binding part 310, so that the spacing distance between the outermost second terminal 310a in FIG. 9 and the adjacent boundary in the second binding part 310 is increased, which makes the pressure exerted by the pressure head concentrate on the conductive particles 500 in the binding region 311, thereby remedying the technical problem in which there is the difference between the pressure to which the conductive particles 500 on both side regions are subjected and the pressure to which the conductive particles on the middle region is subjected. This makes the contact area between the conductive particles 500 on the middle region and the terminals on both sides equal to the contact area between the conductive particles 500 in the edge region and the terminals on both sides.

Meanwhile, on a basis of FIG. 4, the arrangement of the filling part 312a of the present application can reduce the step difference between the first extension part 320 and the second extension part 330 in the filling region 312 and improve the surface flatness of the flexible circuit board 300.

In the present embodiment, the filling part 312a can function as a separate structure and directly bonded to the lowermost single-layer plate 400 in the filling region 312; Alternatively, the filling part 312a may directly be a structure integrally provided with the first extension part 320 and the second extension part 330 in FIG. 6.

In the display module 100 of the present application, please refer to FIGS. 6 and 9. The spacing distance W between the outermost second terminal 310a of the plurality of second terminals 310a and the adjacent boundary in the second binding part 310 may be greater than 1.5 mm.

On the basis of FIG. 6, the present application can also directly remove the structure of the lowermost single-layer plate 400 in the filling region 312, that is, representing that the structure of the second binding part 310 is the same as the structure of the second binding part 310 in FIG. 8, and the filling part 312a in the filling region 312 may be a structure integrally provided with the first extension part 320 and the second extension part 330.

Meanwhile, please refer to Figures 2 and 4. The flexible circuit board 300 of the present application further includes an output part 340. The output part 340 is connected to the side of the second extension part 330 away from the first extension part 320. The output part 340 is connected to the target signal terminal.

The present application also proposes a display device, which includes the above display module. The display device may include an electronic device such as a mobile phone, a television, and a laptop.

In the above embodiments, each of the embodiments has its own emphasis in description. For the parts that are not described in detail in a certain embodiment, please refer to the relevant descriptions of other embodiments.

The technical solutions provided by the embodiments of the present application have been described in detail above. The present disclosure uses specific embodiments to illustrate the principles and implementation methods of the present application. The description of the above embodiments is only used to help understand the technical solutions of the present application and its core idea; Those of ordinary skill in the art should understand that it is still possible to modify the technical solutions recorded in the foregoing embodiments, or to equivalently replace some of the technical features; However, these modifications or substitutions do not cause the essence of the corresponding technical solutions to depart from the scope of the technical solutions of the embodiments of the present application.

## Claims

1. A display module, wherein, comprising:
a display panel comprising a display part, a first binding part located at a side of the display part and a wiring part located between the first binding part and the display part, the first binding part is provided with a plurality of first terminals;
a flexible circuit board, comprising:
a second binding part, the second binding part being provided with a plurality of second terminals, and the second terminals being bound and connected to the corresponding first terminals;
a first extension part connected to the second binding part, the first extension part extending from the second binding part toward the display part, and an orthographic projection of the first extension part on the display panel is located in the wiring part;
a second extension part connected to the second binding part, the second extension part extending from the second binding part to a side away from the first extension part;
wherein, in a direction from the first extension part to the second extension part, a width of the first extension part is greater than a width of the second extension part, and the width of the second extension part is greater than two-thirds of the width of the first extension part.

2. The display module according to claim 1, wherein the second binding part, the first extension part and the second extension part each comprise a single-layer plate, and a number of the single-layer plate stacked in the first extension part and the second extension part is greater than a number of the single-layer plate in the second binding part.

3. The display module according to claim 2, wherein a number of the single-layer plate of the second binding part is one layer, and a number of the single-layer plate of the first extension part is less than or equal to a number of the single-layer plate of the second extension part.

4. The display module according to claim 2, wherein the single-layer plate comprises:
an insulating substrate;
a first conductive layer provided on a surface of the insulating substrate at a side close to the display panel;
a first insulating layer provided on a surface of the first conductive layer at a side close to the display panel;
a second conductive layer provided on a surface of the insulating substrate at a side away from the display panel;
a second insulating layer provided on a surface of the second conductive layer at a side close to the display panel.

5. The display module according to claim 1, wherein the second extension part is provided with an adsorption region and a functional region, and a functional element is provided in the functional region;
wherein, the adsorption region is not overlapped with the functional region.

6. The display module according to claim 5, wherein on a surface of the second extension part away from the display panel, a surface roughness of the adsorption region is smaller than a surface roughness of the functional region.

7. The display module according to claim 5, wherein the second extension part comprises three adsorption regions, two of the adsorption regions are provided on both sides of the second extension part, and one of the adsorption regions is provided in a central area of the second extension part.

8. The display module according to claim 5, wherein both a width and a length of the adsorption region range from 6 mm to 8 mm.

9. The display module according to claim 1, wherein in a first direction, a length of the second binding part is less than a length of the first extension part, and a length of the second binding part is less than a length of the second extension part, the first direction is perpendicular to a direction from the first extension part to the second extension part.

10. The display module according to claim 1, wherein in a first direction, a length of the second binding part is equal to both a length of the first extension part and a length of the second extension part, the first direction is perpendicular to a direction from the first extension part to the second extension part.

11. The display module according to claim 10, wherein the second binding part comprises a binding region and a filling region provided on both sides of the binding region, and the plurality of the second terminals are provided in the binding region;
wherein, each of the filling regions is further provided with a filling part, and a sum of the thickness of the filling part and a thickness of the second binding part is equal to a thickness of the first extension part or a thickness of the second extension part.

12. The display module according to claim 11, wherein the filling part is integrally provided with the first extension part and the second extension part.

13. The display module according to claim 11, wherein a spacing distance between the outermost second terminal among the plurality of second terminals and an adjacent boundary in the second binding part is greater than 1.5 mm.

14. The display module according to any one of claims 1 to 13, wherein a driving chip is further provided in the wiring part, and a first opening is opened at a side of the first extension part toward the display panel and the driving chip is accommodated in the first opening.

15. The display module according to claim 14, wherein a plurality of alignment marks are provided in the wiring part, and the plurality of alignment marks are not overlapped with the first extension part.

16. The display module according to any one of claims 1 to 13, wherein the first extension part is provided with two pressing regions, and the two pressing regions are respectively provided on both ends of the first extending part.

17. The display module according to claim 16, wherein both a width and a length of the pressing region range from 6 mm to 8 mm.

18. The display module according to any one of claims 1 to 13, wherein the flexible circuit board further comprises an output part, the output part is connected to a side of the second extension part away from the first extension part.

19. The display module according to any one of claims 1 to 13, wherein the first terminals on both sides of the first binding part are respectively connected to a sensing electrode line and a drive electrode wire of a touch layer in the display panel.

20. A display device, wherein the display device comprises the display module according to any one of claims 1 to 20.
